# EUROPÄISCHE PATENTSCHRIFT

(11) **EP 1 929 544 B1**
(45) Veröffentlichungstag und Bekanntmachung des Hinweises auf die Patenterteilung: **08.08.2018**
(21) Anmeldenummer: 06775932.4
(22) Anmeldetag: 08.09.2006
(51) Int. Cl.: H01L 33/00, H01L 33/48, H01L 33/58

(54) **STRAHLUNGSEMITTIERENDES BAUELEMENT UND VERFAHREN ZUR HERSTELLUNG EINES STRAHLUNGSEMITTIERENDEN BAUELEMENTS**
RADIATION-EMITTING ELEMENT AND METHOD FOR PRODUCING A RADIATION-EMITTING ELEMENT
COMPOSANT EMETTEUR DE RAYONNEMENT ET PROCEDE POUR PRODUIRE UN COMPOSANT EMETTEUR DE RAYONNEMENT

(30) Priorität: 30.09.2005 DE 102005047063; 13.07.2006 DE 102006032428
(43) Veröffentlichungstag der Anmeldung: 11.06.2008
(73) Patentinhaber: OSRAM Opto Semiconductors GmbH, 93055 Regensburg (DE)
(72) Erfinder: BLÜMEL, Simon, 84069 Schierling (DE); BRAUNE, Bert, 93173 Wenzenbach (DE)
(74) Vertreter: Epping - Hermann - Fischer
(86) Internationale Anmeldenummer: PCT/DE2006/001571
(87) Internationale Veröffentlichungsnummer: WO 2007/036193

(56) Entgegenhaltungen:
- EP-A- 1 484 802
- EP-A- 1 566 847
- EP-A1- 0 400 176
- EP-A1- 1 398 563
- EP-A1- 1 691 425
- WO-A-97/12404
- WO-A-2006/021179
- WO-A1-2006/089523
- WO-A2-2004/070839
- DE-A1- 3 732 075
- JP-A- 2 037 784
- JP-A- 3 085 749
- JP-A- 3 254 162
- JP-A- 9 083 018
- JP-A- 62 150 894
- JP-A- 2000 089 694
- JP-A- 2006 080 251

## Beschreibung

Die Erfindung betrifft ein strahlungsemittierendes Bauelement, das ein optisches Element und einen Gehäusekörper aufweist. Des Weiteren betrifft die Erfindung ein Verfahren zur Herstellung eines derartigen Bauelements.

Verschiedene Lichtquellen sind in den Druckschriften JP 2000-089694, JP 02-37784, EP 1566847, EP 1484802, EP 0400176, JP 09-83018, WO 2006/021179, WO 2006/089523 und EP 1691425 A1 beschrieben. Ferner ist aus der Offenlegungsschrift DE 199 45 675 A1 ein oberflächenmontierbares LED-Gehäuse bekannt, in dem ein LED-Chip angeordnet ist. Dem Chip ist eine Linse nachgeordnet, die ein thermoplastisches Material enthält. Die Linse ist an eine Verkapselung des Chips angebracht.

Bei einer Linse, die an eine Verkapselung angebracht ist, besteht die Gefahr einer Ablösung. Einerseits kann dies von einer geringen Haftung eines für die Verkapselung verwendeten Materials, beispielsweise Silikon, an der Linse herrühren, andererseits kann eine geringe mechanische Beständigkeit eines verwendeten Haftmittels die Ursache sein.

Es ist Aufgabe der vorliegenden Erfindung, ein strahlungsemittierendes Bauelement anzugeben, das eine mechanisch stabile Verbindung zwischen einem optischen Element und einem Gehäusekörper aufweist. Diese Aufgabe wird durch ein strahlungsemittierendes Bauelement gemäß Patentanspruch 1 gelöst.

Ferner ist es Aufgabe der vorliegenden Erfindung, ein Verfahren zur Herstellung eines strahlungsemittierenden Bauelements, das eine mechanisch stabile Verbindung zwischen einem optischen Element und einem Gehäusekörper aufweist, anzugeben. Diese Aufgabe wird durch ein Verfahren gemäß dem unabhängigen Verfahrensanspruch 12 gelöst. Vorteilhafte Weiterbildungen des strahlungsemittierenden Bauelements und Ausgestaltungen des Verfahrens sind in den abhängigen Ansprüchen angegeben.

Ein erfindungsgemäßes strahlungsemittierendes Bauelement umfasst ein optisches Element und einen Gehäusekörper, der eine Befestigungsvorrichtung aufweist, die in das optische Element eingreift oder dieses umgreift und ein Thermoplastmaterial enthält, wobei
die Befestigungsvorrichtung an einem dem optischen Element zugewandten Ende thermisch umgeformt und dadurch derart gebogen oder mit Vorsprüngen versehen ist, dass das optische Element an dem Gehäusekörper irreversibel fixiert ist. Ferner weist das strahlungsemittierende Bauelement einen strahlungsemittierenden Halbleiterkörper auf.

Eine Verankerung des optischen Elements am Gehäusekörper mittels der Befestigungsvorrichtung ermöglicht eine mechanisch stabile Verbindung zwischen dem optischen Element und dem Gehäusekörper, die gegenüber thermischen oder mechanischen Einwirkungen vergleichsweise unempfindlich ist.

Gemäß einer bevorzugten Ausführungsform weist die Befestigungsvorrichtung die Gestalt einer Wand auf, die derart gebogen ist, dass sie einen Vorsprung des optischen Elements einfasst. Der Vorsprung ist auf einer dem Gehäusekörper zugewandten Rückseite des optischen Elements und dieses umlaufend ausgebildet.

Besonders bevorzugt ragt die Befestigungsvorrichtung aus einer beispielsweise planen Oberfläche des Gehäusekörpers heraus und berandet ein Strahlungsfenster des Gehäusekörpers. Ein dem optischen Element zugewandtes Ende der Befestigungsvorrichtung ist in Richtung des optischen Elements umgebogen und umgibt den Vorsprung formschlüssig. Damit ist das optische Element am Gehäusekörper einerseits irreversibel fixiert. Andererseits kann dadurch eine gute Abdichtung des strahlungsemittierenden Bauelements gegenüber schädigenden Medien, beispielsweise Gasen oder Flüssigkeiten, erzielt werden, die das Bauelement alterungsstabiler macht.

Ein Querschnitt der Befestigungsvorrichtung hat beispielsweise die Form eines kreisförmigen oder mehreckigen Ringes. Allgemein ist die Form der Befestigungsvorrichtung an das optische Element angepasst, so dass diese das optische Element formschlüssig umgibt.

Gemäß einer weiteren bevorzugten Ausführungsform umfasst die Befestigungsvorrichtung mindestens zwei Befestigungselemente. Diese können zapfenförmig oder kammartig ausgebildet sein. Dabei weist das optische Element Vertiefungen auf, die in ihrer Größe zumindest der Größe der Befestigungselemente entsprechen. In den Vertiefungen sind die Befestigungselemente angeordnet beziehungsweise eingesteckt.

Besonders bevorzugt sind die Vertiefungen als Durchgangslöcher ausgebildet. Somit können die in den Vertiefungen angeordneten Befestigungselemente von der Seite des optischen Elements aus umgebogen werden.

Hohlräume zwischen den Vertiefungen und den Befestigungselementen können zumindest teilweise mit einem Material aufgefüllt sein, das einem dem Material des optischen Elements entsprechenden Brechungsindex aufweist. Vorteilhafterweise bleiben dadurch optische Eigenschaften des optischen Elements, das zur Strahlformung vorgesehen ist, im Wesentlichen unverändert.

Gemäß einer bevorzugten Ausgestaltung ist das optische Element beabstandet vom Gehäusekörper angebracht. Insbesondere besteht zwischen dem optischen Element und dem Gehäusekörper ein Spalt, der bei Erwärmung eine Ausdehnung eines Materials mit einem größeren Ausdehnungskoeffizienten als angrenzende Materialien kompensiert. Dies kann die Gefahr von Rissbildungen aufgrund thermischer Spannungen verringern. Erfindungsgemäß umfasst der Gehäusekörper mindestens einen strahlungsemittierenden Halbleiterkörper, der typischerweise in einer Ausnehmung angeordnet und in eine Umhüllung eingebettet ist. Da die Umhüllung ein bei Wärmeeinwirkung, beispielsweise durch Löten oder thermisches Umformen, sich stärker als der Gehäusekörper oder das optische Element ausdehnendes Material, beispielsweise Silikon, enthält, erweist sich eine Beabstandung von optischem Element und Gehäusekörper als besonders vorteilhaft.

Der strahlungsemittierende Halbleiterkörper kann eine Leuchtdiode, insbesondere ein Dünnfilm-Leuchtdioden-Chip, sein.

Ein Dünnfilm-Leuchtdioden-Chip zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 µm oder weniger, insbesondere im Bereich von 10 um auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdioden-Chip ist in guter Näherung ein Lambert'scher Oberflächenstrahler.

Die Ausnehmung, in welcher der Halbleiterkörper angeordnet ist, kann trichterartig ausgebildet sein und zusammen mit dem optischen Element die von dem Halbleiterkörper erzeugte Strahlung formen.

Der strahlungsemittierende Halbleiterkörper kann Strahlung im kurzwelligen, insbesondere blauen oder ultravioletten, Spektralbereich emittieren.

Zur Erzeugung kurzwelliger Strahlung ist besonders ein strahlungsemittierender Halbleiterkörper geeignet, der eine aktive Schichtenfolge oder zumindest eine Schicht aufweist, die ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Ein strahlungsemittierendes Bauelement mit einem solchen Halbleiterkörper ist ferner dazu geeignet, längerwellige Strahlung zu emittieren, wenn dem Halbleiterkörper in Abstrahlrichtung ein Konversionselement zur Konversion der kurzwelligen Strahlung in längerwellige Strahlung nachgeordnet ist. Desweiteren ist es dazu geeignet, durch eine Mischung von Strahlung unterschiedlicher Wellenlänge mischfarbiges beziehungsweise "weißes" Licht zu erzeugen.

Vorzugsweise enthält die Umhüllung für einen Wellenlängenkonversion Partikel aus Lumineszenz-Konversionsmaterialien. Geeignete Lumineszenz-Konversionsmaterialien, wie etwa ein YAG:Ce Pulver, sind z.B. in der WO 98/12757 beschrieben. Erfindungsgemäß weist der Gehäusekörper ein Thermoplastmaterial auf. Da ein solches Material verhältnismäßig gut formbar ist, kann die Befestigungsvorrichtung mit relativ geringem technischem beziehungsweise thermischem Aufwand gebogen werden. Besonders bevorzugt ist die Befestigungsvorrichtung mittels eines Prägestempels gebogen.

Ferner ist es möglich, dass der Gehäusekörper ein Keramikmaterial enthält.

Erfindungsgemäß besteht das optische Element aus einem Material, das bei der zur thermischen Umformung der Befestigungsvorrichtung vorherrschenden Temperatur die Formstabilität des optischen Elements gewährleistet.

Weiterhin ist das optische Element unter Strahlungseinwirkung, insbesondere kurzwelliger Strahlung, stabil gegenüber Trübungen oder Verfärbungen. Insbesondere ist das optische Element gegenüber einer dauerhaften Einwirkung kurzwelliger Strahlung vergleichsweise hoher Intensität, die zum Beispiel bei Hochleistungs-Lumineszenzdioden-Bauelementen auftreten kann, stabil ausgebildet. Die Gefahr einer strahlungsbedingten Änderung der Strahlformungseigenschaften oder der Transmission des optischen Elements kann so insgesamt während des Betriebs verringert werden.

Erfindungsgemäß enthält das optische Element ein Duroplastmaterial, Silikon oder Epoxid. Weiterhin kann das optische Element ein Silikonharz, ein Duroplastmaterial wie Epoxidharz oder ein Hybridmaterial, das Silikon und Epoxid enthält, aufweisen.

Bei einer weiteren bevorzugten Ausgestaltung des strahlungsemittierenden Bauelements ist das optische Element ein refraktives Element, ein diffraktives Element oder ein dispersives Element. Die Strahlformung erfolgt bei refraktiven Elementen durch Brechung, gegebenenfalls über einen ortsabhängigen Brechungsindex (GRIN: GRadienten INdex), bei diffraktiven Elementen durch Beugung und bei dispersiven Elementen durch die Wellenlängenabhängigkeit des Brechungsindizes.

Beispielsweise ist das optische Element als Linse, etwa diffraktive oder refraktive Linse, oder Reflektor, vorzugsweise jeweils mit einem Fokus oder Fokalbereich, ausgebildet, der dem Halbleiterkörper zugeordnet ist.

Die Befestigungsvorrichtung kann mit dem Gehäusekörper einstückig ausgebildet sein. Alternativ, wenn möglicherweise verschiedene Materialien für die Befestigungsvorrichtung und den Gehäusekörper gewünscht sind, kann die Befestigungsvorrichtung als separates Element an den Gehäusekörper angeformt sein.

Erfindungsgemäß ist die Befestigungsvorrichtung thermisch umgeformt, das heißt, dass die Befestigungsvorrichtung unter Wärmeeinfluss gebogen beziehungsweise mit Vorsprüngen versehen ist. Besonders bevorzugt wird dafür ein Prägestempel verwendet, wobei die Befestigungsvorrichtung durch das Aufprägen des Stempels gebogen beziehungsweise mit Vorsprüngen versehen wird. Die Befestigungsvorrichtung verhindert dann eine Ablösung des optischen Elements, und das optische Element ist irreversibel am Gehäusekörper fixiert.

Weiterhin kann das strahlungsemittierende Bauelement als SMD (Surface Mount Device)-Bauelement ausgebildet sein, wie es beispielsweise aus dem Artikel "SIEMENS SMT-TOPLED für die Oberflächenmontage" von F. Möllmer und G. Waitl (Siemens Components 29 (1991), Heft 4, S. 147) bekannt ist.

Im Folgenden wird ein Verfahren zur Herstellung eines erfindungsgemäßen strahlungsemittierenden Bauelements angegeben. Das strahlungsemittierende Bauelement kann über die bereits genannten Merkmale hinaus die im Zusammenhang mit dem Verfahren genannten Merkmale aufweisen.

Gemäß dem erfindungsgemäßen Verfahren werden ein optisches Element, das ein Duroplastmaterial, ein Silikon oder ein Epoxid enthält, und ein Gehäusekörper, der eine Befestigungsvorrichtung aufweist, bereitgestellt. Das optische Element wird relativ zum Gehäusekörper so positioniert, dass die Befestigungsvorrichtung in das optische Element eingreift oder dieses umgreift. Dann wird die Befestigungsvorrichtung mittels thermischem Umformen an einem dem optischen Element zugewandten Ende umgeformt, wobei die Befestigungsvorrichtung gebogen wird oder an der Befestigungsvorrichtung Vorsprünge ausgeformt werden derart, dass das optische Element an dem Gehäusekörper irreversibel fixiert wird. Dabei gewährleistet das Material, aus dem das optische Element besteht, bei der zur thermischen Umformung der Befestigungsvorrichtung vorherrschenden Temperatur die Formstabilität des optischen Elements. Erfindungsgemäß wird die Befestigungsvorrichtung zumindest teilweise erwärmt, so dass diese plastisch umformbar, aber nicht fließfähig ist. Erfindungsgemäß enthält die Befestigungsvorrichtung ein Thermoplastmaterial, wobei geeignete Temperaturen zur Umformung der Befestigungsvorrichtung im Bereich der Glasübergangstemperatur, Schmelztemperatur oder Plastifiziertemperatur liegen. Ein thermisches Umformen, insbesondere Nieten, Heißpressen oder Verstemmen, der Befestigungsvorrichtung erfolgt vorzugsweise unter anderem mittels eines Prägestempels.

Verfahrenstechnisch ist beim Nieten zwischen dem Warmumform-, Heißstempel- und Heißluftnieten zu unterscheiden.

Beim Warmumformnieten erwärmt ein Heizstempel die Befestigungsvorrichtung und biegt diese im selben Herstellungsschritt unter Druck beziehungsweise formt einen Vorsprung aus. Anschließend wird der Stempel abgehoben, und die umgeformte Befestigungsvorrichtung kann auf Umgebungstemperatur abkühlen. Eine Material-Rückstellung der umgeformten Befestigungsvorrichtung kann über die Einstellung der Bearbeitungstemperatur gering gehalten werden. Bei amorphen Thermoplasten liegt eine geeignete Bearbeitungstemperatur unterhalb der Glasübergangstemperatur und bei teilkristallinen Kunststoffen zwischen der Schmelz-und der Glasübergangstemperatur.

Vorteilhafterweise ist das Warmumformnieten ein vergleichsweise kostengünstiges Verfahren. Besonders vorteilhaft sind die kurzen Prozesszeiten.

Beim Heißstempelnieten erfolgt die Wärmeeinbringung separat von der Umformung der Befestigungsvorrichtung. Zunächst wird die Befestigungsvorrichtung durch einen heißen Stempel erwärmt. Anschließend wird die Befestigungsvorrichtung mit einem Kaltstempel umgeformt beziehungsweise der Vorsprung ausgeformt. Obwohl die Stempeltemperatur im allgemeinen über 300°C beträgt, kann durch eine nachgeschaltete Kühlphase unter Druckeinfluss und Formzwang eine geringere Relaxation des Kunststoffes als beim Warmumformnieten erreicht werden. Allerdings liegt beim Heißstempelnieten eine vergleichsweise lange Prozesszeit vor.

Das Heißluftnieten arbeitet in der Erwärmungsphase kontaktlos. Ein kontinuierlich umlaufender Heißluftstrom erwärmt die Befestigungsvorrichtung. Auch hier erfolgt die Erwärmung separat von der Umformung. Durch die nachgeschaltete Kühlphase unter Druckeinfluss und Formzwang kann ebenfalls eine geringe Relaxation des Kunststoffes erreicht werden. Die Bearbeitungsstemperatur liegt in der Regel höher als 300°C.

Beim Heißpressen wird die Befestigungsvorrichtung durch Erwärmung und mechanische Krafteinwirkung umgeformt.

Eine thermische Umformung kann vor oder nach einer Montage des strahlungsemittierenden Bauelements, beispielsweise auf einer Leiterplatte, durchgeführt werden.

Bei einer besonderen Ausgestaltung des Verfahrens wird der Gehäusekörper mittels Spritzguss, Pressguss oder Spritzpressguss hergestellt. Derartige Verfahren sind zur kostengünstigen Serienproduktion besonders geeignet. Desweiteren kann auch das optische Element mittels Spritzguss, Pressguss oder Spritzpressguss hergestellt werden.

Insbesondere können der Gehäusekörper und das optische Element mittels eines 2-K-Spritzgusses hergestellt werden. Gemäß einer bevorzugten Variante wird ein Leiterrahmen mit dem bereits montierten und kontaktierten Halbleiterkörper in eine Spritzgussform eingeführt und mit einer Formmasse umspritzt, so dass ein spritzgegossener Gehäusekörper entsteht. Mittels eines darauf folgenden Spritzgusses, Pressgusses oder Spritzpressgusses wird das optische Element bevorzugter Weise zeitnah, besonders bevorzugt solange die Formmasse des Gehäusekörpers noch warm ist, auf der Formmasse des Gehäusekörpers spritzgegossen. Das optische Element ist als Folge formschlüssig mit dem Gehäusekörper verbunden. Da eine Oxidation der Formmasse des Gehäusekörpers dann noch gering ist, kann eine gute Haftung zwischen dem optischen Element und dem Gehäusekörper erzielt werden. Vorteilhafterweise kann dadurch die Verankerung des optischen Elements am Gehäusekörper verstärkt werden.

Gemäß einer weiter bevorzugten Ausführung wird das optische Element mittels eines 2-K-Spritzgusses hergestellt. Dies ist insbesondere dann von Vorteil, wenn das optische Element einen Vorsprung oder Sockel aufweist, der ein vom Grundkörper verschiedenes Material enthält.

Weitere bevorzugte Merkmale, vorteilhafte Ausgestaltungen und Weiterbildungen sowie Vorteile eines strahlungsemittierenden Bauelements gemäß der Erfindung ergeben sich aus den im Folgenden im Zusammenhang mit den Figuren 1 bis 4 näher erläuterten Ausführungsbeispielen.

Es zeigen:
Figuren 1a und 1b eine schematische Querschnittsansicht eines ersten Ausführungsbeispiels eines erfindungsgemäßen strahlungsemittierenden Bauelements mit ungebogener (Figur 1a) und gebogener Befestigungsvorrichtung (Figur 1b),
Figuren 2a und 2b ein schematische Querschnittsansicht eines zweiten Ausführungsbeispiels eines erfindungsgemäßen strahlungsemittierenden Bauelements aufweisend eine Befestigungsvorrichtung ohne Vorsprünge (Figur 2a) und mit Vorsprüngen (Figur 2b),
Figur 3a eine schematische Seitenansicht und Figur 3b eine schematische Aufsicht eines dritten Ausführungsbeispiels eines erfindungsgemäßen strahlungsemittierenden Bauelements,
Figur 4a eine schematische Seitenansicht und Figur 4b eine schematische Aufsicht eines vierten Ausführungsbeispiels eines erfindungsgemäßen strahlungsemittierenden Bauelements.

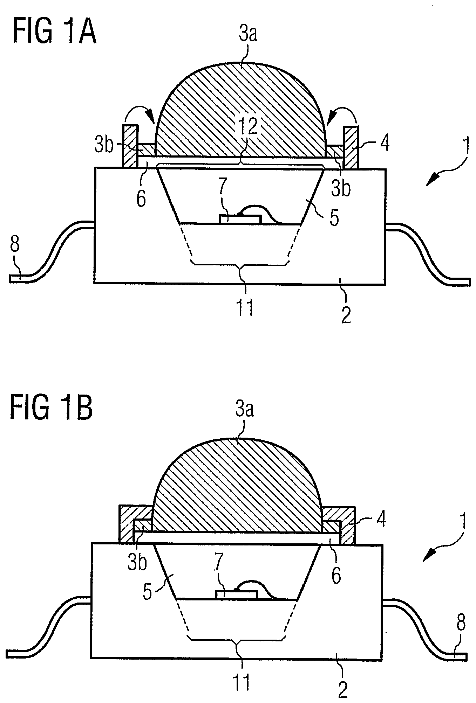

In Figur 1a ist ein strahlungsemittierendes Bauelement 1 dargestellt, das einen Gehäusekörper 2 und ein optisches Element umfasst. Das optische Element, das als Sammellinse ausgebildet ist, weist einen Grundkörper 3a und auf seiner Rückseite einen den Grundkörper 3a umlaufenden Vorsprung 3b auf.

Das optische Element ist rückseitig in einer Befestigungsvorrichtung 4 angeordnet, die dieses umgreift. Insbesondere ist die Befestigungsvorrichtung 4 als eine das optische Element 3 umgebende Wand ausgebildet, die den Querschnitt eines kreisförmigen Ringes aufweist.

Die Befestigungsvorrichtung wird in Pfeilrichtung gebogen, so dass das optische Element an dem Gehäusekörper 2 irreversibel fixiert ist.

Vorzugsweise ist das optische Element beabstandet zum Gehäusekörper 2 angeordnet, so dass das strahlungsemittierende Bauelement 1 einen Spalt 6 aufweist. Dies hat den Vorteil, dass die Ausdehnung einer Umhüllung 5 bei Erwärmung kompensiert werden kann, wodurch die Gefahr verspannungsbedingter Rissbildungen, die aufgrund unterschiedlicher Ausdehnungskoeffizienten des Gehäusekörpers 2, der Umhüllung 5 und des optischen Elements auftreten können, reduziert ist.

Typischerweise füllt die Umhüllung 5 eine Ausnehmung 11 aus. In der Ausnehmung 11 ist ein strahlungsemittierender Halbleiterkörper 7 angeordnet, der in die Umhüllung 5 eingebettet ist. Zweckmäßigerweise enthält die Umhüllung 5 ein für vom Halbleiterkörper 7 erzeugte Strahlung transparentes und degradationsstabiles Material. Ein geeignetes Material ist bei kurzwelliger Strahlung beispielsweise ein Silikon oder Silikonharz.

Vorzugsweise ist die Ausnehmung 11 trichterartig ausgebildet und mit einem reflexionssteigernden Material versehen. Somit kann sie zur Strahlformung beitragen. Die Ausnehmung 11 gibt im Gehäusekörper 2 ein Strahlungsfenster 12 frei, durch welches die von dem strahlungsemittierenden Halbleiterkörper 7 emittierte Strahlung in das optische Element gelangen kann. Der Gehäusekörper 2 umfasst einen zweiteiligen Leiterrahmen 8, wobei der Halbleiterkörper 7 auf einem ersten Teil des Leiterrahmens rückseitig angeordnet und mit einem zweiten Teil vorderseitig mittels eines Drahtes verbunden ist. Mittels des Leiterrahmens 8 ist das strahlungsemittierende Bauelement 1 an eine elektrische Energieversorgung anschließbar.

In Figur 1b ist die gebogene Befestigungsvorrichtung 4 dargestellt, die den Vorsprung 3b des optischen Elements einfasst und somit eine Vertikalbewegung des optischen Elements relativ zum Gehäusekörper 2 verhindert. Die gebogene Befestigungsvorrichtung 4 umgibt das optische Element formschlüssig.

Die Befestigungsvorrichtung 4 wird thermisch umgeformt. Wie im allgemeinen Teil beschrieben kann dies durch Nieten erfolgen. Die Befestigungsvorrichtung 4 enthält ein thermoplastisches Material. Das optische Element enthält hingegen ein duroplastisches Material und ist bei der verwendeten Bearbeitungstemperatur formstabil.

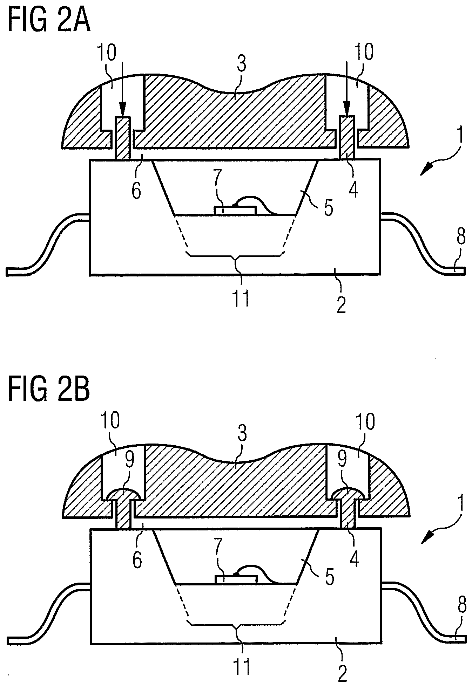

Das in den Figuren 2a und 2b dargestellte Ausführungsbeispiel eines strahlungsemittierenden Bauelements 1 ist wie das erste Ausführungsbeispiel als SMD-Bauelement ausgeführt. Allerdings weist es im Gegensatz zum ersten Ausführungsbeispiel ein den Gehäusekörper 2 abdeckendes optisches Element 3 auf.

Bei dem optischen Element 3 handelt es sich um eine Linse, die aus einer zentral angeordneten Konkavlinse und einer die Konkavlinse umlaufenden Konvexlinse besteht. Mit einer derartigen Linse ist es möglich, die von dem Halbleiterkörper 7 erzeugte Strahlungsenergie in einen verhältnismäßig großen Raumwinkel zu verteilen. Das mit der Linse versehene Bauelement 1 ist besonders zur homogenen Ausleuchtung, beispielsweise zur Hinterleuchtung von Displays, geeignet.

Das optische Element 3 weist Vertiefungen 10 auf, die sich von der Vorderseite bis zur Rückseite des optischen Elements 3 erstrecken. Die Vertiefungen 10 verjüngen sich zur Rückseite hin.

Die Befestigungsvorrichtung 4 greift rückseitig in die Vertiefungen 10 ein. Sie umfasst zwei zapfenförmige Befestigungselemente, die sich passgenau in den verjüngten Teil der Vertiefungen 10 einfügen.

In Pfeilrichtung wird die Befestigungsvorrichtung 4 an ihrem dem optischen Element 3 zugewandten Ende mit Vorsprüngen versehen, so dass das optische Element 3 an dem Gehäusekörper 2 irreversibel fixiert ist.

Zwischen dem optischen Element 3 und dem Gehäusekörper 2 besteht wie beim ersten Ausführungsbeispiel ein Spalt 6, der zur Kompensation von bei Erwärmung sich ausdehnendem Material, insbesondere dem Material der Umhüllung 5, vorgesehen ist. Desweiteren kann der Spalt 6 mit einem Material gefüllt sein, das einen Brechungsindexsprung an der Grenze zwischen dem Gehäusekörper 2 und dem optischen Element 3 abschwächt.

Figur 2b zeigt das in Figur 2a dargestellte strahlungsemittierende Bauelement 1 nach einer Ausbildung von Vorsprüngen 9. Diese sind kopfartig geformt und verhindern an der verjüngten Stelle ein Herausrutschen des optischen Elements 3 aus der Befestigungsvorrichtung 4. Die Vorsprünge 9 werden gemäß einem der im allgemeinen Teil beschriebenen Verfahren durch thermisches Umformen der Befestigungsvorrichtung 4 hergestellt. Nachträglich können die Vertiefungen mit einem Material aufgefüllt werden, das einen dem optischen Element 3 entsprechenden Brechungsindex aufweist. Somit können die optischen Eigenschaften des optischen Elements 3 gewahrt bleiben.

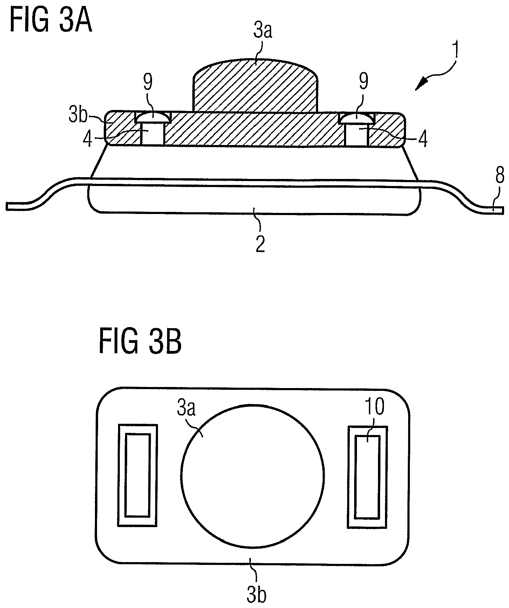

In Figur 3a ist ein strahlungsemittierendes Bauelement 1 dargestellt, dessen Gehäusekörper 2 dem ersten und zweiten Ausführungsbeispiel entsprechende (teilweise nicht dargestellte) Elemente aufweist.

Die Befestigungsvorrichtung 4 weist zwei Befestigungselemente auf, wobei sich beide Elemente kammartig auf dem Gehäusekörper 2 erstrecken und das Fenster 12 teilweise beranden. Das optische Element weist für die Befestigungsvorrichtung 4 passende Vertiefungen 10 auf, wie in Figur 3b dargestellt.

Das optische Element umfasst einen Grundkörper 3a und einen Sockel 3b mit den Vertiefungen 10. Aufgrund der Anordnung der Vertiefungen 10 im Sockel 3b können die optischen Eigenschaften des Grundkörpers 3a unbeeinflusst bleiben.

Das optische Element ist vorzugsweise einstückig mittels Spritzguss hergestellt, wobei die Vertiefungen 10 bei der Herstellung ausgespart werden. Alternativ können die Vertiefungen 10 nach der Herstellung in das optische Element eingebracht werden.

Wie in Figur 3a dargestellt weisen die Vertiefungen 10 einen T-förmigen Querschnitt auf und sind ferner, wie Figur 3b zeigt, langgestreckt.

Die Befestigungsvorrichtung 4 greift in die Vertiefungen 10 ein und weist an ihrem dem Grundkörper 3a zugewandten Ende Vorsprünge 9 auf, die nach einem Zusammenfügen des optischen Elements und des Gehäusekörpers 2 durch thermisches Umformen gebildet sind. Die Befestigungsvorrichtung 4 und die Vorsprünge 9 ergeben zusammen eine den Vertiefungen 10 entsprechende T-Form.

Bei diesem Ausführungsbeispiel werden das optische Element und der Gehäusekörper 2 entlang zweier gegenüberliegender Seiten des strahlungsemittierenden Bauelements 1 zusammengehalten, wodurch sich im Vergleich zu einer punktuellen Fixierung mittels zweier Zapfen eine besonders stabile Befestigung ergibt.

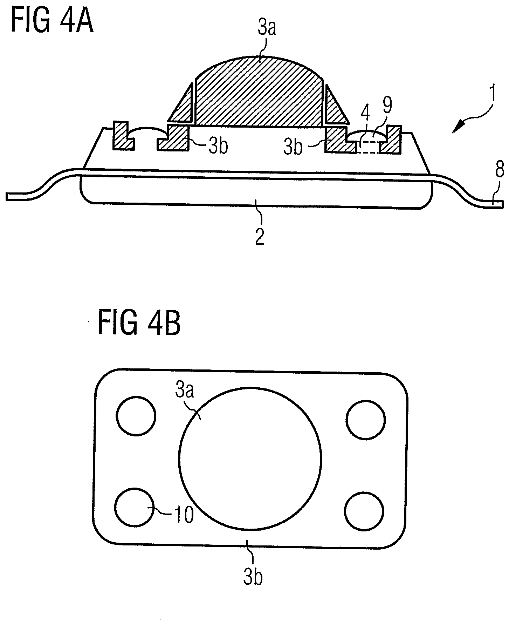

Bei dem in den Figuren 4a und 4b dargestellten strahlungsemittierenden Bauelement 1 weist die Befestigungsvorrichtung 4 vier zapfenförmige Befestigungselemente auf. Diese sind im Gehäusekörper 2 versenkt. Auch der Sockel 3b kann im Gehäusekörper 2 versenkt werden, wodurch der Grundkörper 3a im Vergleich zum dritten Ausführungsbeispiel näher an den Gehäusekörper heranreicht. Die Befestigungselemente weisen an ihrem dem Grundkörper 3a zugewandten Ende Vorsprünge 9 auf, die vorzugsweise mittels Heißpressen ausgebildet sind und das optische Element irreversibel am Gehäusekörper 2 fixieren.

Die Erfindung ist nicht durch die Beschreibung anhand der Ausführungsbeispiele beschränkt.

## Patentansprüche

1. Strahlungsemittierendes Bauelement (1) mit
- einem strahlungsemittierenden Halbleiterkörper (7),
- einem optischen Element (3), das ein Duroplastmaterial, ein Silikon oder ein Epoxid enthält, und
- einem Gehäusekörper (2), der mindestens eine Befestigungsvorrichtung (4) aufweist, die in das optische Element (3) eingreift oder dieses umgreift und ein Thermoplastmaterial enthält, wobei die Befestigungsvorrichtung (4) an einem dem optischen Element (3) zugewandten Ende thermisch umgeformt und dadurch derart gebogen oder mit Vorsprüngen (9) versehen ist, dass das optische Element (3) an dem Gehäusekörper (2) irreversibel fixiert ist, und wobei das optische Element (3) aus einem Material besteht, das bei einer zur thermischen Umformung der Befestigungsvorrichtung (4) vorherrschenden Temperatur die Formstabilität des optischen Elements (3) gewährleistet.

2. Strahlungsemittierendes Bauelement (1) nach Anspruch 1, wobei
die Befestigungsvorrichtung (4) die Gestalt einer Wand aufweist, die derart gebogen ist, dass sie einen Vorsprung (3b) des optischen Elements einfasst.

3. Strahlungsemittierendes Bauelement (1) nach Anspruch 2, wobei
ein Querschnitt der Befestigungsvorrichtung (4) die Form eines kreisförmigen oder mehreckigen Ringes aufweist.

4. Strahlungsemittierendes Bauelement (1) nach Anspruch 1, wobei
die Befestigungsvorrichtung (4) zapfenförmige oder kammartige Befestigungselemente aufweist.

5. Strahlungsemittierendes Bauelement (1) nach Anspruch 4, wobei
das optische Element (3) der Befestigungsvorrichtung (4) angepasste Vertiefungen (10) aufweist, in welche die Befestigungsvorrichtung (4) eingesteckt ist.

6. Strahlungsemittierendes Bauelement (1) nach Anspruch 5, wobei
Hohlräume in den Vertiefungen (10) zumindest teilweise mit einem Material gefüllt sind, das einen dem Material des optischen Elements (3) entsprechenden Brechungsindex aufweist.

7. Strahlungsemittierendes Bauelement (1) nach einem der vorhergehenden Ansprüche, wobei
das optische Element (3) beabstandet von dem Gehäusekörper (2) angebracht ist.

8. Strahlungsemittierendes Bauelement (1) nach Anspruch 7, wobei
zwischen dem Gehäusekörper (2) und dem optischen Element (3) ein Spalt (6) gebildet ist zur Kompensation einer thermischen Ausdehnung einer Umhüllung (5).

9. Strahlungsemittierendes Bauelement (1) nach einem der vorhergehenden Ansprüche, wobei
der Gehäusekörper (2) ein Thermoplastmaterial enthält.

10. Strahlungsemittierendes Bauelement (1) nach einem der vorhergehenden Ansprüche, wobei
das optische Element (3) ein refraktives Element, ein diffraktives Element oder ein dispersives Element ist.

11. Strahlungsemittierendes Bauelement (1) nach einem der vorhergehenden Ansprüche, wobei
die Befestigungsvorrichtung (4) an den Gehäusekörper (2) angeformt ist.

12. Verfahren zur Herstellung eines strahlungsemittierenden Bauelements (1) aufweisend einen strahlungsemittierenden Halbleiterkörper (7), ein optisches Element (3), das ein Duroplastmaterial, ein Silikon oder ein Epoxid enthält, und einen Gehäusekörper (2) mit einer Befestigungsvorrichtung (4), die ein Thermoplastmaterial enthält, mit den Schritten:
- Positionieren des optischen Elements (3) relativ zu dem Gehäusekörper so, dass die Befestigungsvorrichtung (4) in das optische Element (3) eingreift oder dieses umgreift,
- Thermisches Umformen der Befestigungsvorrichtung (4) an einem dem optischen Element (3) zugewandten Ende, wobei die Befestigungsvorrichtung gebogen wird oder an der Befestigungsvorrichtung Vorsprünge ausgeformt werden derart, dass das optische Element (3) an dem Gehäusekörper (2) irreversibel fixiert wird, und wobei das optische Element (3) aus einem Material besteht, das bei einer zur thermischen Umformung der Befestigungsvorrichtung (4) vorherrschenden Temperatur die Formstabilität des optischen Elements (3) gewährleistet.

13. Verfahren nach Anspruch 12,
wobei die Befestigungsvorrichtung (4) mittels eines Prägestempels umgeformt wird.

14. Verfahren nach Anspruch 12 oder 13, wobei
die Befestigungsvorrichtung (4) mittels Nieten, Heißpressen oder Verstemmen umgeformt wird.

15. Verfahren nach einem der Ansprüche 12 bis 14, wobei der Gehäusekörper (2) mittels Spritzgusses, Pressgusses oder Spritzpressgusses hergestellt wird.

16. Verfahren nach einem der Ansprüche 12 bis 15,
wobei der Gehäusekörper (2) und das optische Element (3) mittels 2-K-Spritzgusses hergestellt werden.

17. Verfahren nach einem der Ansprüche 12 bis 16,
wobei das optische Element (3) mittels 2-K-Spritzgusses hergestellt wird.

## Claims

1. Radiation emitting device (1) with
- a radiation emitting semiconductor body (7),
- an optical element (3) containing a thermoset material, a silicone or an epoxy, and
- a housing body (2) which comprises at least one fastening device (4) which engages or encompasses the optical element (3) and contains a thermoplastic material, wherein the fastening device (4) is thermally formed at one end facing the optical element (3) and thereby bent or provided with protrusions (9), in such a way that the optical element (3) is irreversibly fixed to the housing body (2), and wherein the optical element (3) consists of a material which ensures the form stability of the optical element (3) at a temperature prevailing for thermal forming of the fastening device (4).

2. Radiation emitting device (1) according to claim 1, wherein
the fastening device (4) has the shape of a wall, bent in such a way as to enclose a protrusion (3b) of the optical element.

3. Radiation emitting device (1) according to claim 2, wherein
a cross-section of the fastening device (4) has the form of a circular or polygonal ring.

4. Radiation emitting device (1) according to claim 1, wherein
the fastening device (4) comprises cone-shaped or comb-shaped fastening elements.

5. Radiation emitting device (1) according to claim 4, wherein
the optical element (3) of the fastening device (4) comprises adapted depressions (10) into which the fastening device (4) is inserted.

6. Radiation emitting device (1) according to claim 5, wherein
cavities in the depressions (10) are at least partially filled with a material having a refractive index corresponding to the material of the optical element (3).

7. Radiation emitting device (1) according to one of the preceding claims, wherein
the optical element (3) is mounted at a distance from the housing body (2).

8. Radiation emitting device (1) according to claim 7, wherein
a gap (6) is formed between the housing body (2) and the optical element (3) to compensate for a thermal expansion of an enclosure (5).

9. Radiation emitting device (1) according to one of the preceding claims, wherein
the housing body (2) contains a thermoplastic material.

10. Radiation emitting device (1) according to one of the preceding claims, wherein
the optical element (3) is a refractive element, a diffractive element or a dispersive element.

11. Radiation emitting device (1) according to one of the preceding claims, wherein
the fastening device (4) is molded onto the housing body (2).

12. A method of manufacturing a radiation emitting device (1) comprising a radiation emitting semiconductor body (7), an optical element (3) containing a thermoset material, a silicone or an epoxy, and a housing body (2) having a fastening device (4) containing a thermoplastic material, comprising the steps of:
- positioning the optical element (3) relative to the housing body in such a way that the fastening device (4) engages or encompasses the optical element (3),
- thermal forming of the fastening device (4) at one end facing the optical element (3), wherein the fastening device is bent or protrusions are formed on the fastening device such that the optical element (3) is irreversibly fixed to the housing body (2), and wherein the optical element (3) consists of a material which ensures the form stability of the optical element (3) at a temperature prevailing for thermal forming of the fastening device (4).

13. Method according to claim 12, wherein
the fastening device (4) is formed by means of an embossing die.

14. Method according to claim 12 or 13, wherein
the fastening device (4) is formed by riveting, hot pressing or caulking.

15. Method according to one of claims 12 to 14, wherein
the housing body (2) is produced by injection molding, pressure molding or transfer molding.

16. Method according to one of claims 12 to 15, wherein
the housing body (2) and the optical element (3) are produced by 2-component injection molding.

17. Method according to one of claims 12 to 16, wherein
the optical element (3) being produced by 2-component injection molding.

## Revendications

1. Composant (1) émetteur de rayonnement, comprenant
- un corps semi-conducteur (7) émetteur de rayonnement,
- un élément optique (3) qui contient une matière thermodurcissable, une silicone ou un époxyde, et
- un corps de boîtier (2) qui présente au moins un dispositif de fixation (4) qui a prise dans l'élément optique (3) ou qui a prise entoure celui-ci et contient une matière thermoplastique,
le dispositif de fixation (4) étant formé thermiquement sur une extrémité tournée vers l'élément optique (3) et étant ainsi courbé ou muni de saillies (9) de manière à ce que l'élément optique (3) soit fixé de manière irréversible sur le corps de boîtier (2), et l'élément optique (3) consistant en une matière qui, à une température régnant pour le formage thermique du dispositif de fixation (4), garantit la stabilité de forme de l'élément optique (3).

2. Composant (1) émetteur de rayonnement, selon la revendication 1,
le dispositif de fixation (4) présentant la forme d'une paroi qui est courbée de manière à ce qu'elle borde autour d'une saillie (3b) de l'élément optique.

3. Composant (1) émetteur de rayonnement, selon la revendication 2,
une section transversale du dispositif de fixation (4) présentant la forme d'un anneau circulaire ou polygonal.

4. Composant (1) émetteur de rayonnement, selon la revendication 1,
le dispositif de fixation (4) présentant des éléments de fixation en forme de tourillon ou de peigne.

5. Composant (1) émetteur de rayonnement, selon la revendication 4,
l'élément optique (3) du dispositif de fixation (4) présentant des approfondissements (10) adaptés, dans lesquels le dispositif de fixation (4) est inséré.

6. Composant (1) émetteur de rayonnement, selon la revendication 5,
des espaces creux dans les approfondissements (10) étant remplis au moins en partie avec une matière qui présente un indice de réfraction correspondant à la matière de l'élément optique (3).

7. Composant (1) émetteur de rayonnement, selon l'une quelconque des revendications précédentes,
l'élément optique (3) étant attaché à distance du corps de boîtier (2).

8. Composant (1) émetteur de rayonnement, selon la revendication 7,
une fente (6) étant formée entre le corps de boîtier (2) et l'élément optique (3) pour la compensation d'une dilatation thermique d'une enveloppe (5).

9. Composant (1) émetteur de rayonnement, selon l'une quelconque des revendications précédentes,
le corps de boîtier (2) contenant une matière thermoplastique.

10. Composant (1) émetteur de rayonnement, selon l'une quelconque des revendications précédentes,
l'élément optique (3) étant un élément réfractif, un élément diffractif ou un élément dispersif.

11. Composant (1) émetteur de rayonnement, selon l'une quelconque des revendications précédentes,
le dispositif de fixation (4) étant formé sur le corps de boîtier (2).

12. Procédé de fabrication d'un composant (1) émetteur de rayonnement présentant un corps semi-conducteur (7) émetteur de rayonnement, un élément optique (3) qui contient une matière thermodurcissable, une silicone ou un époxyde, et présentant un corps de boîtier (2) doté d'un dispositif de fixation (4) qui contient une matière thermoplastique, comprenant les étapes :
- positionnement de l'élément optique (3) par rapport au corps de boîtier de manière à ce que le dispositif de fixation (4) ait prise dans l'élément optique (3) ou entoure celui-ci,
- formage thermique du dispositif de fixation (4) sur une extrémité tournée vers l'élément optique (3), le dispositif de fixation étant cintré ou des saillies étant formées sur le dispositif de fixation de manière à ce que l'élément optique (3) soit fixé de manière irréversible sur le corps de boîtier (2), et l'élément optique (3) étant constitué d'une matière qui, à une température régnant pour le formage thermique du dispositif de fixation (4), garantit la stabilité de forme de l'élément optique (3).

13. Procédé selon la revendication 12,
le dispositif de fixation (4) étant formé au moyen d'un poinçon d'estampage.

14. Procédé selon la revendication 12 ou 13,
le dispositif de fixation (4) étant formé par rivetage, pressage à chaud ou matage.

15. Procédé selon l'une quelconque des revendications 12 à 14,
le corps de boîtier (2) étant fabriqué par moulage par injection, moulage sous pression ou moulage par transfert.

16. Procédé selon l'une quelconque des revendications 12 à 15,
le corps de boîtier (2) et l'élément optique (3) étant fabriqués par moulage par injection à deux composants.

17. Procédé selon l'une quelconque des revendications 12 à 16,
l'élément optique (3) étant fabriqué par moulage par injection à deux composants.
